(19) Europäisches Patentamt / European Patent Office / Office européen des brevets

(11) **EP 2 743 328 B1**

(12) **EUROPEAN PATENT SPECIFICATION**

(45) Date of publication and mention
of the grant of the patent:
**09.01.2019 Bulletin 2019/02**

(21) Application number: **12822628.9**

(22) Date of filing: **07.08.2012**

(51) Int Cl.:
*C09K 11/56* (2006.01)          *C09K 11/02* (2006.01)
*H01L 31/055* (2014.01)        *H01L 33/44* (2010.01)
*H01L 33/50* (2010.01)

(86) International application number:
**PCT/JP2012/070057**

(87) International publication number:
**WO 2013/021990 (14.02.2013 Gazette 2013/07)**

(54) **RED PHOSPHOR AND LIGHT-EMITTING ELEMENT**

ROTER PHOSPHOR UND LICHTEMITTIERENDES ELEMENT

MATIÈRE LUMINOPHORE ROUGE ET ÉLÉMENT ÉMETTANT DE LA LUMIÈRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.08.2011 JP 2011175927**

(43) Date of publication of application:
**18.06.2014 Bulletin 2014/25**

(73) Proprietor: **Mitsui Mining and Smelting Co., Ltd.**
**Shinagawa-ku**
**Tokyo 141-8584 (JP)**

(72) Inventors:
• **SASAKURA, Asuka**
  **Saitama 362-0021 (JP)**
• **ITOH, Jun-ichi**
  **Saitama 362-0021 (JP)**
• **INAMURA, Masaaki**
  **Saitama 362-0021 (JP)**
• **KUMAGAI, Akinori**
  **Saitama 362-0021 (JP)**

• **SHIMIZU, Haruka**
  **Saitama 362-0021 (JP)**

(74) Representative: **Gille Hrabal**
**Brucknerstrasse 20**
**40593 Düsseldorf (DE)**

(56) References cited:
**EP-A2- 0 372 560          WO-A1-2004/036962**
**WO-A1-2011/040391      JP-A- 2003 243 715**
**JP-A- 2004 505 172        JP-A- 2009 526 089**
**US-A- 5 985 173            US-A1- 2007 125 984**

• **GUO C ET AL: "Improving the stability of alkaline earth sulfide-based phosphors", APPLIED SURFACE SCIENCE, ELSEVIER, AMSTERDAM, NL, vol. 225, 1 January 2004 (2004-01-01), pages 198-203, XP002469137, ISSN: 0169-4332, DOI: 10.1016/J.APSUSC.2003.10.008**
• **HIROYUKI KASANO ET AL.: 'Cathodoluminescence of Ca1-xMgxS:A (A=Eu or Ce)' J. ELECTROCHEM.SOC. vol. 131, no. 8, 1984, pages 1953 - 1960, XP055143110**

EP 2 743 328 B1

## Description

[Technical field]

The present invention relates to a red phosphor, and specifically to a red phosphor that can be used in a white LED light source, in a fluorescent display tube (VFD), in a field emission display (FED), in electroluminescence (EL) and the like, as well as to a light-emitting element using the same.

[Technical background]

ZnCdS:Ag,Cl phosphors, and the like, have been mainly used as prior art red phosphors, for such reasons as they are chemically stable. However, the use of Cd has become restricted due to environmental problems, and the like, such that development of a novel red phosphor containing no Cd is in demand, and novel red phosphors are being developed.

For instance, a red phosphor is described in Patent Document 1 and Patent Document 2, comprising calcium sulfide as the host material, Eu as a luminescence center (activator) and Mn, Li, Cl, Ce, Gd, and the like, as sensitizers (co-activators).

In addition, a red phosphor represented by either the general formula (1) (Ca,Sr)S:Eu,A,F, (2) (Ca,Sr)S:Eu,Rb,F, or, (3) (Ca,Sr)S:Eu,A,Rb,F (where A in formulae (1) to (3) is at least one species selected from Al, Ga and In, is at 0.01 to 5 mol%, and contains Rb at 0.01 to 2 mol%) is described in Patent Document 3 as a red phosphor allowing satisfactory brightness and efficiency to be obtained along with high color purity even at a low-energy electron excitation.

An orange phosphor is described in Patent Document 4, which is an orange phosphor that is excited by a light in a region from near-ultraviolet to visible, having the same monoclinic crystal structure as $Eu_2SiS_4$, and represented by general formula $(CaBa)_{1-x}Eu_xSiS_4$ when the Eu concentration is x.

A method, in which red light-emitting phosphor particles are dispersed in an anhydrous polar solvent such as alcohol containing a reactive fluoride at a low concentration thereby conferring a transparent fluoride coat to the particles, is described in Patent Document 5 as a method for improving moisture-resistance of red phosphors based on alkaline-earth sulfides such as strontium sulfide, barium sulfide and calcium sulfide. Further WO 2004/036962 discloses a light emitting device comprising europium activated red emitting phosphors.

[Prior art references]

[Patent Documents]

[Patent Document 1] Japanese Patent Application Laid-open No. 2002-80845
[Patent Document 2] Japanese Patent Application Laid-open No. 2003-41250
[Patent Document 3] Japanese Patent Application Laid-open No. 2005-146190
[Patent Document 4] Japanese Patent Application Laid-open No. 2010-215728
[Patent Document 5] Japanese translation of PCT international application No. 2002-527570

[Summary of the invention]

[Problems to be solved by the invention]

The CaS:Eu series red phosphor described in Patent Document 3 above, having a narrow peak width at half-height and being capable of demonstrating deep red color is very suitable for instance for back-light phosphors, or the like. However, this species of CaS:Eu series red phosphor have the problem that, due to reacting readily with water, if stored or used in the atmosphere, they react with moisture or the like in the atmosphere and become hydrolyzed, deteriorating the phosphor and decreasing the emission intensity. Therefore, they are difficult to put into practice for instance as LED phosphors.

In addition, for phosphors containing sulfur such as CaS, problematic points have been pointed out, such as, hydrogen sulfide gas being generated due to reaction between the sulfur and water, this hydrogen sulfide gas, particularly when the phosphors are used in a white LED element, inhibits curing of the silicone resin mixed with the phosphor, corrodes metal members inside the element such as Ag-plating film (hereafter referred to as "Ag reflective film") provided in order to elevate the reflectance of the lead frame, decreasing the reflective performance thereof or becoming a cause of electrical defects such as disconnection.

Thus, an object of the present invention is to provide a novel CaS:Eu series red phosphor in which moisture-resistance has been improved, and further preferably, a novel CaS:Eu series red phosphor capable of suppressing effectively the negative effects of hydrogen sulfide gas.

[Means for solving the problems]

The present invention proposes a red phosphor containing Ba at 0.001 to 1.00 mol% with respect to CaS or $(Ca_{1-x}Sr_x)S$ in a red phosphor represented by general formula: CaS:Eu or general formula: $(Ca_{1-x}Sr_x)S$:Eu (where $0 < x \le 1$), in other words, a red phosphor doped to contain Ba at a concentration of 0.001 to 1.00 mol% with respect to CaS or $(Ca_{1-x}Sr_x)S$ in a red phosphor having CaS or $(Ca_{1-x}Sr_x)S$ (where $0 < x \le 1$) as a host material and Eu as a luminescence center (activator), wherein Ba is not substituted at a site of the crystal lattice of the phosphor, and the Ba atoms penetrate into the crystal lattice of the phosphor or are present outside the crystal lattice.

The present invention further proposes a red phosphor provided with a constitution comprising a metal oxide, or, a metal oxide layer containing a metal oxide, present on the red phosphor particle surface.

[Effects of the invention]

In a red phosphor represented by CaS:Eu or $(Ca_{1-x}Sr_x)S$:Eu (where $0 < x \le 1$), doping with a small amount of Ba was shown to allow moisture-resistance to be improved. According to general knowledge in the art of phosphors, doping with on the order of 10 mol% of a dopant with a different ionic radius to adjust the colors, or the like, is common. In contrast, it was not only unknown but also unpredictable that doping with an extremely small amount of Ba of 1.00 mol% or less as in the present invention could improve moisture-resistance. That is to say, as the solubilities of BaS and CaS are described to be 9.40 g/100 g water (30°C) and 1.98 g/1 dm$^3$ water (30°C) respectively according to Chemistry Handbook (Revision 4) Basic Edition 2, BaS has a higher solubility than CaS by far and has the property of being prone to deterioration by moisture absorption. Therefore, when those of ordinary skills in the art were to design based on widely-known techniques of the art, since the moisture-resistance of a phosphor doped with the more moisture-absorption-prone Ba is known to deteriorate obviously, the effect of the invention of the moisture-resistance being improved is completely unexpected.

Since metal oxides have the property of adsorbing sulfur chemically, when a metal oxide or a metal oxide layer is present on the surface of a phosphor particle, even if, for instance, S (sulfur) from CaS or (Ca,Sr)S and moisture in the air react and a hydrogen sulfide gas is generated, as the metal oxide on the phosphor surface absorbs this, the negative effects of the hydrogen sulfide gas can be suppressed effectively.

As described above, since the moisture-resistance is improved and, further preferably, the negative effects of hydrogen sulfide gas are also suppressed effectively, the red phosphor proposed by the present invention is particularly suitable as a red phosphor used, for instance, in a white LED light source, in a fluorescent display tube (VFD), in a field emission display (FED), in electroluminescence (EL), and the like, as well as a light-emitting element.

[Modes for carrying out the invention]

Embodiments of the invention will be detailed in the following; however, the scope of the present invention is not limited to the embodiments described below.

< First embodiment >

The red phosphor according to a first embodiment of the invention (hereafter called "the red phosphor 1") is a red phosphor doped to contain Ba at a concentration of 0.001 to 1.00 mol% with respect to CaS or (Ca,Sr)S in a red phosphor having CaS or (Ca,Sr)S as a host material and Eu as a luminescence center (activator).

The host material of the red phosphor 1 can be represented by CaS or $(Ca_{1-x}Sr_x)S$.

In $(Ca_{1-x}Sr_x)S$, the maximum emission wavelength (emission peak wavelength) can be adjusted by by adjusting the strontium content (x). That is to say, since the maximum emission wavelength of CaS:Eu is 660 nm and the maximum emission wavelength of SrS:Eu is 610 nm, the emission wavelength can be controlled arbitrarily between the above maximum emission wavelengths (610 nm to 660 nm) by adjusting the content ratios of calcium and strontium. It suffices to adjust the content ratio (x) of strontium in a range of greater than 0 but 1 or less according to the application; for instance, from the point of view of luminosity factor, 0.5 to 1 is desirable and in particular 0.8 to 1 is more desirable. In addition, from the point of view of red color purity, 0 to 0.5 is desirable and in particular 0 to 0.2 is more desirable.

It is desirable that the luminescence center of the red phosphor 1 is the divalent $Eu^{2+}$. In the case of the trivalent ($Eu^{3+}$), Eu is not solid-solubilized into the host material, decreasing the red brightness.

It is desirable that the content ratio of Eu is 0.01 to 5 mol% with respect to CaS or (Ca,Sr)S and in particular 0.05 mol% or greater or 2 mol% or less is desirable.

From the point of view of moisture-resistance improvement effect, it is important that the Ba content (concentration) in the red phosphor 1 is 0.001 to 1.00 mol% with resect to CaS or (Ca,Sr)S. The moisture-resistance improvement effect cannot be obtained if less than 0.001 mol% or more than 1.00 mol%. From such points of view, it is desirable that, among above range, the Ba content (concentration) in the red phosphor is 0.002 mol% or greater or 0.400 mol% or less, of which 0.004 mol% or greater or 0.300 mol% or less is all the more desirable.

While adding Ba to adjust the color tone has been performed in prior art, since the amounts added for color alteration are on the order of at least 5 mol, that is 5 mol/%, as indicated in Table 2·2·16, page 137 of Non-patent Document 1 ("Phosphor Handbook", edited by the Phosphor Research Society of Japan; Ohm Ltd; 25 Dec.1987), paragraph [0009] of Patent Document 6 (Japanese Patent Application Laid-open No. 2007-224148), and the like, the amounts added are completely different, and the technical meaning is different from adding 0.001 to 1.00 mol% Ba from the point of view of moisture-resistance improvement effect.

In Patent Document 6, the purpose of adding an amount of Ba so large as to substitute sites in the crystal lattice was to shift the maximum emission wavelength (emission peak wavelength) of the phosphor serving as the host material phase. Meanwhile, with the amount of Ba added in the present invention, the Ba atoms penetrate into the crystal lattice of the phosphor or are present outside the crystal lattice, Ba is not substituted at a site of the crystal lattice of the phosphor, and no effect of shifting the maximum emission wavelength of the phosphor was observed. The Ba added according to the present invention is thought to be present as a compound such as $BaSO_4$ on the outer layer of the phosphor.

The red phosphor 1 may be a powder or a formed body. In the case of a powder, from the point of view of dispersibility, it is desirable that the center particle size (D50) according to a volume-based particle size distribution obtained through measurement by a laser diffraction scattering grain size distribution measurement method is 0.1 $\mu$m to 100 $\mu$m, 1 $\mu$m or greater or 50 $\mu$m or less is more desirable and 2 $\mu$m or greater or 20 $\mu$m or less is particularly desirable. If D50 is 0.1 $\mu$m or greater, the emission efficiency does not tend to decrease and, in addition, phosphor particles do not aggregate either. In addition, if 100 $\mu$m or less, coating irregularities and clogging of dispensers or the like can be prevented while maintaining dispersibility.

It suffices to adjust the center particle size (D50) of the red phosphor 1 according to the application since it can be adjusted by adjusting the particle size of the raw materials of the host material, that is to say, of the Ca raw materials.

(Production method)

Hereafter, an example of preferred production method for the red phosphor 1 will be described. However, there is no limitation to the production method described below.

The red phosphor 1 can be obtained, for instance, by respectively weighing Ca raw materials and Ba raw materials, or further Sr raw materials, mixing the raw materials, as necessary drying, then, primary firing in a hydrogen sulfide gas atmosphere, next, adding Eu raw materials, secondary firing in a reducing atmosphere, and as necessary annealing.

As the Sr raw materials and Ca raw materials, while the respective oxides, sulfides, complex oxides, carbonates, and the like, can be cited in addition to simple metal bodies, sulfides are desirable.

As Eu raw materials, europium compounds (Eu salts) such as EuS, $Eu_2O_3$ and Eu can be cited.

As Ba raw materials, while oxides, sulfides, complex oxides, carbonates, and the like, of Ba can be cited, sulfides are desirable.

Mixing of the raw materials can be carried out either dry or wet. When dry-mixing, while not limiting the mixing method in particular, for instance, using zirconia balls as media, mixing with a paint shaker, a ballmill, or the like (for instance, on the order of 90 minutes), and as necessary drying so as to obtain a raw materials mixture, is adequate.

When wet-mixing, bringing the raw materials into a suspended state using a non-aqueous solvent, similarly to above, using zirconia balls as media, mixing with a paint shaker, a ballmill, or the like, then separating the media with a sieve or the like, removing the solvent from the suspension by a suitable drying method such as reduced pressure drying and vacuum drying so as to obtain a raw materials mixture, is adequate.

Prior to firing, as necessary, the raw materials mixture obtained as described above may be subjected to grinding, sorting and drying. However, grinding, sorting and drying do not have to be performed necessarily. In addition, the obtained powder may be formed as necessary. For instance, forming is possible under the conditions of Ø20 mm and approximately 620 kg/cm$^2$.

For primary firing, firing in a hydrogen sulfide gas atmosphere at 700 to 1,100°C for one hour to 24 hours is desirable.

Meanwhile, for secondary firing, firing in a reductive atmosphere or a non-acidic atmosphere at 900 to 1,300°C for one hour to 24 hours is desirable. As atmosphere for secondary firing, reducing atmosphere such as argon gas, nitrogen gas, hydrogen sulfide gas, a nitrogen gas atmosphere containing a small amount of hydrogen gas and a carbon dioxide atmosphere containing carbon monoxide, can be adopted. Of these, firing under an inert gas atmosphere such as argon gas and nitrogen gas is desirable.

If the temperature of the secondary firing is 900°C or higher, even when a carbonate is used for the raw materials, decomposition of carbon dioxide can be carried out sufficiently, in addition, the effect of Eu diffusion into the CaS host material can be obtained sufficiently. Meanwhile, if 1,300°C or lower, uniform microparticles can be obtained without provoking abnormal particle growth. In addition, if the firing time is one hour or more, reproducibility of the substance properties can be obtained, and if within 24 hours, an increase in substance scattering can be suppressed, allowing composition variations to be suppressed.

After the primary firing or the secondary firing, the particle size may be adjusted as necessary by grinding and sorting.

In addition, after firing or grinding, as necessary annealing is adequate. In so doing, as annealing conditions, heating to 400 to 1,300°C in an inert gas atmosphere such as argon gas and nitrogen gas, a hydrogen atmosphere, a hydrogen sulfide atmosphere, an oxygen atmosphere and an air atmosphere, is desirable.

<Second embodiment>

The red phosphor according to a second embodiment of the present invention (hereafter called "the red phosphor 2") is a red phosphor provided with a constitution in which a metal oxide, or, a metal oxide layer containing a metal oxide, is present on the particle surface of the red phosphor 1 described above.

(Metal oxide)

As the metal oxide, for instance, oxides of silicon, magnesium, aluminum, zinc, titanium, boron, strontium, calcium, barium, tin, phosphorus, yttrium, zirconium, gadolinium, indium, lutetium, lanthanum and the like, can be cited. These oxides may exist in a crystallized state, or, in addition, in a vitrified state. Such metal oxides have the characteristic of reacting with hydrogen sulfide gas, and the characteristic of not absorbing light from an LED, or the like, and not affecting the color, in other words, of being white transparent.

From various test results so far, the metal oxides mentioned above can mitigate the influence of hydrogen sulfide gas if present as metal oxide microparticles such as ZnO compound microparticles on the surface of a sulfur-containing phosphor. In so doing, it has been confirmed that there was no need to coat the surface of the sulfur-containing phosphor as a metal oxide layer comprising continuously joined metal oxide particles. Thus, it does not matter if a portion exists on the surface of the sulfur-containing phosphor with no metal oxide attached.

Obviously, it does not matter if the surface of the sulfur-containing phosphor is coated with a metal oxide layer comprising continuously joined metal oxide particles, which is a preferred embodiment. Such a metal oxide layer may contain a constituent other than the metal oxide particle.

In addition, it is desirable that the metal oxide and the sulfur of the phosphor are not chemically bonded. This is because if they were chemically bonded, the reaction with the hydrogen sulfide gas would become inhibited. Thus, it suffices that the metal oxide is physically attached on the surface of the sulfur-containing phosphor.

Among the metal oxides described above, from the points of view of reactivity with hydrogen sulfide gas, and of not absorbing light from an LED, or the like, and of not affecting the color, zinc oxides, that is to say, ZnO compounds containing Zn and O, are particularly desirable.

Regarding ZnO compounds, the specific composition thereof is not limited. For instance, one species or two or more species of crystalline microparticles chosen from the group comprising $ZnO$, $Zn(OH)_2$, $ZnSO_4 \cdot nH_2O$ ($0 \leq n \leq 7$), $ZnAl_2O_4$ and $ZnGa_2O_4$ can be cited, and those with other composition are adequate.

Further in addition, an organic acid zinc salt such as zinc stearate is adequate.

It is desirable that the metal oxides, in particular ZnO compounds are microparticles of 0.3 $\mu$m or less in average particle size according to SEM or TEM observation, and in particular, it is more desirable that the average particle size is 1 nm or greater, or 100 nm or less. If the average particle size is 0.3 $\mu$m or less, the ZnO compound particle does not scatter the light emitted from the LED, and the phosphor is not prevented from absorbing the light emitted from the LED, which is thus desirable. In addition, since the purpose of coating the ZnO compound is to adsorb hydrogen sulfide gas, also from this point, it is desirable that the specific surface area of the ZnO compound is larger, and can be stated to be all the more desirable if 100 nm or less.

The average particle size according to SEM or TEM observation is the average particle size of 100 units observed in 10 arbitrary visual fields, and when a particle has an aspect ratio, the mean value of the long axis and the short axis serves as the particle size of the particle.

The mass ratio between the red phosphor 1 and the surface metal oxide is preferably the red phosphor 1: metal oxide = 1:0.005 to 1:1. If the proportion of metal oxide is within the above range, not only the effect of hydrogen sulfide gas adsorption can be obtained, but also the phosphor is not prevented from absorbing the light emitted from the LED and luminescing, allowing the emission efficiency of the phosphor to be maintained. From such points of view, in particular sulfur-containing phosphor:metal oxide = 1:0.01 to 1:0.5 is further desirable, of which in particular 1:0.02 to 1:0.3 is all the more desirable.

As a production method for causing a metal oxide to be present on the surface of the red phosphor 1, adding to a solvent (for instance ethanol) and dispersing by ultrasound a metal oxide powder, adding thereto the red phosphor 1 powder and stirring, then, evaporating the solvent to attach the metal oxide, causing it to be present on the surface of the sulfur-containing phosphor particle, is adequate.

In addition, causing the metal oxide to be attached and present on the surface of the red phosphor 1 particle is also possible by using a blender or the like to dry-mix the red phosphor 1 and the metal oxide powder. After attaching the metal oxide on the surface of the red phosphor 1 particle, firing may be performed. However, there is no need to perform firing that heats at least to 500°C or higher.

In addition, as a production method for forming a metal oxide layer on the surface of the red phosphor 1, for instance, a method such as the chemical gas phase reaction method can be cited.

(Glass coat layer)

If the red phosphor 2 is further provided with a glass layer containing a glass composition, water-resistance can be elevated further.

As morphologies of the red phosphor 2 provided with a glass layer, for instance, a metal oxide may be present on the surface of the red phosphor 1, and a glass layer be provided so as to coat this, in addition, a glass layer may be formed on the surface of the red phosphor 1, and a metal oxide layer may be formed on the surface of the glass layer. Furthermore, the red phosphor 1 may be provided with a coat layer of three layers or more, one arbitrary layer thereof serving as a glass layer and the other arbitrary layers serving as metal oxide layers.

It suffices that the glass layer contains a glass composition, and, for instance, glasses of such composition as $SiO_2$, $B_2O_3$-$SiO_2$, $Ma_2O$-$MbO$-$B_2O_3$-$SiO_2$, (Ma is an alkaline metal, Mb is an alkaline earth metal or Zn) can be cited as glass compositions, without being limited to these.

As a coating method for the glass layer, for instance, preparing a precursor mixture that contains a precursor of the glass coat layer, water and solvent, mixing the precursor mixture and phosphor particles, inducing a sol-gel reaction, coating the surface of the red phosphor 1 with glass, next, through filtering, separating and obtaining only the phosphor particle whereon a glass coat layer has been formed, and then, drying and heating this phosphor particle, is sufficient.

In addition, mixing the red phosphor 1 particle and a powder of glass composition, heating the mixture of powder of glass composition and phosphor particle in such a manner that the powder of glass composition is melted and surrounds the phosphor particle, and then cooling this mixture is also adequate. Otherwise, the method of coating the surface of phosphor particle by a chemical gas phase reaction method, the method of attaching particles of metal compound, and the like, can be also adopted.

In maintaining the light-emission of the phosphor, it is more desirable that the glass layer is compact and continuous. However, if compact and continuous, a portion where no glass layer is attached, exposing the phosphor surface, may be present in a portion on the surface of the phosphor.

While the corrosion of an Ag reflective film can be prevented with only one layer of a glass layer, a layer from a combination with a metal oxide layer may be also formed on the surface of the red phosphor. Forming a structure of two layers or more combined in this way allows the corrosion suppression effect of the Ag reflective film to be raised further.

Whether or not the produced red phosphor particle has the composition of the red phosphor 1 or 2 can be assessed by measuring each element content using a fluorescence X-ray analyzer (XRF), or, an ICP emission analyzer or the like by dissolving totally with hydrochloric acid.

<Light characteristics of the red phosphor 1 and 2>

The red phosphor 1 and 2 are excited by light at a wavelength in the ultraviolet region to visible region (on the order of 250 nm to 610 nm), in particular light at a wavelength in the near-ultraviolet region to blue region (on the order of 300 nm to 510 nm), and emit light in the visible region, in particular red light. The emission spectrum of the red phosphor 1 and 2 have an emission peak in the region of 610 nm to 660 wavelength by photo-excitation at on the order of 300 nm to 610 nm wavelength.

<Application of the red phosphor 1 and 2>

By being disposed in the vicinity of a light-emission source such as, for instance, LED, laser or diode, the red phosphors 1 and 2 can constitute a light-emitting element or device and be used in various applications. For instance, disposing the phosphors over an LED in contact directly or indirectly through an adhesive or a bonding agent is sufficient.

Disposing the red phosphors 1 and 2 in the vicinity of an LED allows them to be used, for instance, in addition to lighting devices and special light sources, in back-lights, or the like, of image display devices such as liquid crystal display devices, or the like. In addition, disposing an electric field source or an electron source in the vicinity of the red phosphors 1 and 2 in the vicinity thereof allows the phosphors to be used in display devices such as EL, FED and CRT. The vicinity of a light-emitter refers to a location where the light emitted by the light-emitter can be received.

More concretely, for instance, it is possible to constitute a wavelength-converting light-emitting element provided at least with one LED chip and the red phosphor 1 or 2, the phosphor absorbing at least a portion of the light emitted from the LED, the light emitted from the LED and the light emitted by the phosphor are mixed is obtained, and this can be used as a light-emitting element of a lighting device or an image display device.

Since the red phosphor 1 and 2, as described above, is excited by a light at a wavelength in the ultraviolet region to visible region (on the order of 250 nm to 610 nm) and emits light in the visible region, in particular red light, the red phosphor 1 and 2 can be used in a solar power generator by using this property. For instance, it is possible to constitute a solar power generator provided with the red phosphor 1 and 2 that receives among the sunlight a light containing at least a light in the ultraviolet region or a light in the near-ultraviolet region and emits a light in the visible region, and a solar battery that receives and converts into electric signal the light in the visible region emitted by the red phosphor 1 and 2. In the case of solar batteries comprising a single crystal silicon, or the like, since those that become excited when receiving a light in the visible region but do not become excited even when receiving a light in the ultraviolet region or a light in the near-ultraviolet region are common, it is possible to elevate the power generation efficiency by using a phosphor to convert light in the ultraviolet region or light in the near-ultraviolet region into visible light and providing it to the solar battery.

Thus, for instance, it is possible to constitute a solar power generator provided with a filter mirror, the red phosphor 1 and 2, a semiconductor thermoelectric element and a solar battery, and constitute the solar power generator in such a way that the sunlight is spectrally separated by the filter mirror into an infrared region (for instance 1,000 nm or greater), a visible· near-infrared region (for instance 450 to 1,000 nm) and an ultraviolet-blue region (250 to 450 nm), the light in the infrared region is irradiated the semiconductor thermoelectric element for heating, the light in the ultraviolet· blue region is irradiated the red phosphor 1 and 2 to be converted into a light in the visible region and irradiated the solar battery along with the light in the visible region spectrally separated by the filter mirror.

In so doing, the red phosphor may be coated onto the light-collecting surface or the heat-collecting pipe to form the phosphor.

<Explanation of the terms>

In the present invention, a "light-emitting element" means a light-emitting device that emits light, provided with at least a phosphor such as a red phosphor and an emission source or an electron source as an excitation source thereof, and a "light-emitting apparatus" means, among the light-emitting elements, a relatively large-scale light-emitting device that emits light provided with at least a phosphor and an emission source or an electron source as an excitation source thereof. In both cases, the placement of the phosphor within the element or apparatus and the positional relationship between the excitation source and the phosphor are not limited to specific ones. Designated are light-emitting devices in which a phosphor converts and utilizes a light received from an excitation source.

In the present invention, the expression "X to Y" (X and Y are any numbers), unless explicitly stated otherwise, includes the meaning "X or greater but Y or less" along with the meanings "preferably larger than X" and "preferably smaller than Y".

In addition, in the present invention, the expression "X or greater" (X is any number), unless explicitly stated otherwise, includes the meaning of "preferably larger than X" and the expression "Y or less" (Y is any number), unless explicitly stated otherwise, includes the meaning of "preferably smaller than Y".

[Examples]

While examples will be indicated below, the present invention is not to be interpreted by being limited to these.

<Measurement of external quantum efficiency>

For the phosphor powders obtained in the examples and comparative examples, the external quantum efficiency was measured in the following manner:
Measurements were carried out using the spectrofluorometer FP-6500 and the integration sphere unit ISF-513 (manufactured by JASCO Corporation) according to a solid-state quantum efficiency computation program. The spectrofluorometer was corrected using a substandard light source and rhodamine B.

Calculation formula (Formula 1) for the external quantum efficiency of a phosphor at 466 nm excitation light is shown below:

[Formula 1]

Let $P_1(\lambda)$ be the spectrum of a reference whiteboard, $P_2(\lambda)$ the spectrum of a sample and $P_3(\lambda)$ the spectrum of an indirectly excited sample. Let the surface $L_1$ comprising the spectrum $P_1(\lambda)$ enclosed by the range of excitati on wavelength 451nm-481 nm be the intensity of excitation.

$$L_1 = \int_{451}^{481} P_1(\lambda)d\lambda$$

Let the surface $L_2$ comprising the spectrum $P_2(\lambda)$ enclosed by the range of excitation wavelength 451 nm-481 nm be the diffusion intensity of the sample.

$$L_2 = \int_{451}^{481} P_2(\lambda)d\lambda$$

Let the surface $E_2$ comprising the spectrum $P_2(\lambda)$ enclosed by the range of excitation wavelength 482nm-648.5nm be the fluorescence intensity of the sample.

$$E_2 = \int_{482}^{648.5} P_2(\lambda)d\lambda$$

Let the surface $L_3$ comprising the spectrum $P_3(\lambda)$ enclosed by the range of excitation wavelength 451 nm-481 nm be the intensity of indirect diffusion.

$$L_3 = \int_{451}^{481} P_3(\lambda)d\lambda$$

Let the surface $E_3$ comprising the spectrum $P_3(\lambda)$ enclosed by the range of excitation wavelength 482nm-648.5nm be the intensity of indirect fluorescence.

$$E_3 = \int_{482}^{648.5} P_3(\lambda)d\lambda$$

The sample absorbance ratio is the ratio of the fraction of excitation light reduced by the sample over the incident light.

$$A = \frac{L_1 - L_2}{L_1}$$

The external quantum efficiency $\varepsilon_{ex}$ is the number of photons $N_{em}$ of the fluorescent light emitted from the sample divided by the number of photons $N_{ex}$ of the excitation light shone on the sample.

$$N_{ex} = k \cdot L_1$$

$$N_{em} = k \cdot (E_2 - \frac{L_2}{L_3} E_3)$$

$$\therefore \varepsilon_{ex} = \frac{N_{em}}{N_{ex}} = \frac{E_2 - \frac{L_2}{L_1}E_3}{L_1}$$

The external quantum efficiency $\varepsilon_{in}$ is the number of photons $N_{em}$ of the fluorescent light emitted from the sample divided by the number of photons $N_{abs}$ of the excitation light absorbed by the sample.

$$N_{ex} = k \cdot (L_1 - L_2)$$

$$N_{em} = k \cdot E_2$$

$$\therefore \varepsilon_{ex} = \frac{N_{em}}{N_{abs}} = \frac{E_2 - \frac{L_2}{L_1}E_3}{L_1 - L_2}$$

(from JASCO FWSQ-6-17(32) Solid-state Quantum Efficiency Calculation Program manual)

<Evaluation of emission maintenance rate of the phosphor>

Phosphor (sample) was mixed at a proportion of 40 wt% into silicone resin, coated over a glass plate into a thickness of approximately 300 $\mu$m, and cured for one hour at 140°C; then, the emission efficiency was measured before and after HAST test for moisture-resistance evaluation of the phosphor. HAST test was carried out according to IEC68-2-66, so as to store the phosphor powder (sample) at 120°C and 85% RH for 20 hours.

The external quantum efficiency (450 nm excitation wavelength) was measured with FP-6500 manufactured by JASCO Corporation, and the emission efficiency was indicated as the maintenance rate when the external quantum efficiency before the HAST test served as 100%.

<Measurement of CIE chromaticity coordinates>

For the phosphor powders obtained in the examples and comparative examples, a spectrofluorometer (FP-6500 manufactured by JASCO

Corporation) was used to measure PL (photoluminescence) spectra. Then, from the PL spectra, brightness color (xy values of CIE chromaticity coordinates) were measured using the following formula:

[Formula 2]

Method for converting CIE (Commission Internationale de l'Eclairage) chromaticity coordinate values.

If the light emission waveform of the sample is P(A)

$$\left.\begin{array}{l} X = K\int_{380}^{780} P(\lambda)\bar{x}(\lambda)d\lambda \\[2mm] Y = K\int_{380}^{780} P(\lambda)\bar{y}(\lambda)d\lambda \\[2mm] Z = K\int_{380}^{780} P(\lambda)\bar{z}(\lambda)d\lambda \end{array}\right\} \quad (1)$$

where,

$$K = \frac{1}{\int_{380}^{780} P(\lambda)\bar{y}(\lambda)d\lambda}$$

The chromaticity coordinate values x and y are calculated from (1)

$$\left.\begin{array}{l} x = \dfrac{X}{X+Y+Z} \\[2mm] y = \dfrac{Y}{X+Y+Z} \end{array}\right\} \quad (2)$$

However, x bar ($\lambda$), y bar ($\lambda$) and z bar (A) are CIE spectral tristimulus values at 2° or 10° field of view, and the spectral tristimulus values at 2° field of view was used in the present specification.

<Examples 1-1 to 1-6 and Comparative Examples 1-1 to 1-3>

$CaCO_3$ and $BaCO_3$ were respectively weighed, these were introduced in pure water, ground and mixed using a beads mill, dried, then fired in a hydrogen sulfide gas atmosphere at 850°C for four hours, next, $Eu_2O_3$ was added and fired in an argon gas atmosphere at 1,000°C for four hours to obtain a red phosphor powder (sample) represented by the general formula CaS: Eu, Ba.

For the obtained red phosphor powder (sample), the content of each element was measured by ICP analysis, at the same time, the external quantum efficiency, the emission maintenance rate and the CIE chromaticity coordinates were measured as above, and the results were indicated in Table 1.

[Table 1]

| | Ba addition concentration | Ba analysis concentration | Emission maintenance rate | CIEx | CIEy |
|---|---|---|---|---|---|
| | (mol%) | (mol%) | (%) | | |
| Example 1-1 | 0.01 | 0.004 | 55 | 0.706 | 0.294 |
| Example 1-2 | 0.05 | 0.022 | 68 | 0.706 | 0.294 |
| Example 1-3 | 0.10 | 0.043 | 75 | 0.706 | 0.294 |
| Example 1-4 | 0.50 | 0.17 | 73 | 0.706 | 0.294 |
| Example 1-5 | 0.75 | 0.28 | 62 | 0.706 | 0.294 |
| Example 1-6 | 0.90 | 0.35 | 53 | 0.706 | 0.294 |
| Comparative Example 1-1 | 0.00 | 0.00 | 38 | 0.706 | 0.294 |
| Comparative Example 1-2 | 5.0 | 2.13 | 10 | 0.707 | 0.293 |
| Comparative Example 1-3 | 10 | 4.5 | 0 | 0.705 | 0.295 |

<Examples 2-1 to 2-6 and Comparative Examples 2-1 to 2-2>

With respect to 100 parts in mass of the sample (red phosphor) obtained in Example 1, 0.5 parts in mass of ZnO (30 nm average particle size) was introduced along with 50 mL of ethanol into an eggplant flask, and ZnO was dispersed in ethanol with an ultrasound cleaner. 10 g of red phosphor from the sample obtained in Example 1 was added thereto, ethanol was evaporated while stirring with an evaporator, to obtain a ZnO-deposited CaS:Eu,Ba phosphor powder (sample).

For the obtained red phosphor powder (sample), the content of each element was measured by ICP analysis, at the same time, the external quantum efficiency, the emission maintenance rate and the CIE chromaticity coordinates were measured as above, and the results were indicated in Table 2.

[Table 2]

| | Ba addition concentration | Ba analysis concentration | Emission maintenance rate | CIEx | CIEy |
|---|---|---|---|---|---|
| | (mol%) | (mol%) | (%) | | |
| Example 2-1 | 0.01 | 0.004 | 78 | 0.708 | 0.294 |
| Example 2-2 | 0.05 | 0.025 | 82 | 0.707 | 0.293 |
| Example 2-3 | 0.10 | 0.037 | 81 | 0.706 | 0.294 |
| Example 2-4 | 0.50 | 0.23 | 88 | 0.707 | 0.293 |
| Example 2-5 | 0.75 | 0.33 | 85 | 0.706 | 0.294 |
| Example 2-6 | 1.0 | 0.41 | 77 | 0.707 | 0.293 |
| Comparative Example 2-1 | 0 | 0 | 66 | 0.706 | 0.294 |
| Comparative Example 2-2 | 5.0 | 2.3 | 55 | 0.707 | 0.293 |

When the samples obtained in Example 2-1 to 2-6 and Comparative Examples 2-1 to 2-2, that is to say, ZnO-deposited CaS:Eu,Ba phosphors were observed with an SEM ("XL30-SFEG", manufactured by FEI), primary particles of ZnO partially attached in an aggregated state on the surface of the CaS:Eu,Ba phosphor particle, and the surface of the phosphor particle was partially exposed. In so doing, the average particle size of the primary particles of ZnO did not change from the average particle size of the raw materials.

<Examples 3-1 to 3-3 and Comparative Examples 3-1 to 3-3>

$CaCO_3$, $SrCO_3$ and $BaCO_3$ were respectively weighed, these were introduced in pure water, ground and mixed using a beads mill, dried, then fired in a hydrogen sulfide gas atmosphere at 850°C for four hours, next, $Eu_2O$ was added and fired in an argon gas atmosphere at 1,000°C for four hours to obtain a red phosphor powder (sample) represented by the general formula $(Ca_{1-x}Sr_x)S$ (where $0 < x \leq 1$):Eu,Ba.

For the obtained red phosphor powder (sample), the content of each element was measured by ICP analysis, at the same time, the external quantum efficiency, the emission maintenance rate and the CIE chromaticity coordinates were measured as above, and the results were indicated in Table 3.

[Table 3]

| | ICP analysis concentration (mol%) | | | Emission maintenance rate | CIEx | CIEy |
|---|---|---|---|---|---|---|
| | Ca concentration | Sr concentration | Ba concentration | (%) | | |
| Example 3-1 | 80.23 | 19.68 | 0.09 | 98 | 0.702 | 0.298 |
| Example 3-2 | 39.47 | 60.45 | 0.08 | 87 | 0.696 | 0.304 |
| Example 3-3 | 21.28 | 78.63 | 0.09 | 63 | 0.685 | 0.315 |
| Comparative Example 3-1 | 79.63 | 20.37 | 0.00 | 43 | 0.703 | 0.297 |
| Comparative Example 3-2 | 49.87 | 50.13 | 0.00 | 11 | 0.697 | 0.303 |
| Comparative Example 3-3 | 19.33 | 80.67 | 0.00 | 0 | 0.686 | 0.314 |

<Comparative Example 4-1>

In 150 mL of methanol, 2.9 g of $BaCl_2$ was added and dissolved by stirring. To the obtained solution, 10 g of CaS:Eu phosphor was added, and ammonia was added drop-wise until the pH reached 8 to obtain a slurry. The obtained slurry was filtered, dried at 120°C for two hours, the obtained dry powder was fired in atmospheric at 700°C for two hours to obtain a red phosphor powder (sample).

For the obtained red phosphor powder (sample), the content of each element was measured by ICP analysis, at the same time, the external quantum efficiency, the emission maintenance rate and the CIE chromaticity coordinates were measured as above.

<Discussion>

The red phosphor represented by the general formula: CaS:Eu, doping with Ba in small amounts was found to allow moisture-resistance to be improved, from the measurement results of the emission maintenance rate.

From the results of various tests and examples and comparative examples thus far, it can be considered that, for the effects of such small amount Ba doping, similar effects can be anticipated if doping is performed in such a way that the concentration of Ba is to be 0.001 to 1.00 mol%. It was found from the CIE that the emission color was not affected with such a concentration range. However, as in Comparative Example 4-1, since the emission maintenance rate was 35% and deterioration was not improved even if a surface coat layer containing Ba was formed, it was found to be desirable for deterioration improvement that Ba is present inside the phosphor.

In addition, for such effects, similar effects were observed in the cases of red phosphors in which a ZnO compound or a ZnO compound layer is present on the red phosphor particle surface, moreover, in these cases, it was also confirmed that by attaching a ZnO compound containing Zn and O on the surface of the sulfur-containing phosphor could for instance prevent an Ag reflective film from being corroded by a generated hydrogen sulfide gas. This is thought to be due to the generated hydrogen sulfide gas being chemically adsorbed by the ZnO compound on the sulfur-containing phosphor surface.

In so doing, as is also clear from the synthesis method of the examples, it was found that if the ZnO compound does not fully cover the entirety of the surface of the sulfur-containing phosphor and instead is attached and dispersed on the surface, it could adsorb chemically the generated hydrogen sulfide gas, allowing the desired effects to be obtained.

In addition, when the chemical property of adsorbing the generated hydrogen sulfide gas onto the ZnO compound on the sulfur-containing phosphor surface and the lack of influence on the color are considered, it is possible to consider that similar effects are obtained if the composition of the ZnO compound is, in addition to ZnO, for instance, $Zn(OH)_2$, $ZnSO_4 \cdot nH_2O$ ($0 \leq n \leq 7$), $ZnAl_2O_4$ and $ZnGa_2O_4$ and the like.

In addition, it is possible to consider that, similar effects are obtained also with an organic salt of zinc such as zinc stearate.

It has been also observed that water-resistance could be further increased by layering a glass layer containing glass in addition to the ZnO compound layer in which a ZnO compound is dispersed on the surface of the sulfur-containing phosphor.

In so doing, when the function of increasing water-resistance and the function of adsorbing hydrogen sulfide gas are considered, it is possible to consider that the layering order of the ZnO compound layer and the glass layer may be any, and the constitution may comprise the ZnO compound layer and the glass layer layered in order from the surface of the sulfur-containing phosphor, or the constitution may comprise the glass layer and the ZnO compound layer layered in order from the surface of the sulfur-containing phosphor.

<Example 4>

The red phosphor powder obtained in Example 3-1 was added at a proportion of 20 wt% with respect to polyether sulfone (PES), and a sheet-forming apparatus comprising a single-axis kneading extruder, a T-die extrusion molding machine and a winder connected in series was used to prepare a 200 $\mu$m-thick fluorescent sheet.

This fluorescent sheet was placed over a solar battery panel and a transparent resin sheet serving a protection sheet was further placed over the fluorescent sheet to constitute a solar power unit.

Constituting a solar power unit in this way allows a wavelength conversion layer to be formed on the solar battery panel. In such a wavelength conversion layer, it is desirable that phosphor particles of 0.1 $\mu$m to 100 $\mu$m are dispersed inside the transparent resin.

In a solar power unit of such a constitution, when sunlight shines from above, it is supplied through the transparent resin sheet to the fluorescent sheet, the red phosphor that has received the sunlight becomes excited by light at 250 nm to 610 nm wavelength, in particular light at 300 nm to 510 nm wavelength, allowing a light in the visible region, in particular red light, to be emitted and supplied to the solar battery panel. At the solar battery panel, light in the visible region is received and the red phosphor becomes excited, allowing power to be generated.

Forming a film of phosphor on the transparent resin sheet by a physical vapor deposition method such as sputtering or electron beam vapor depositing the red phosphor (powder) obtained in Example 3-1 onto the transparent resin sheet is adequate. In so doing, crystallinity can be increased by annealing after forming the film.

In addition, alternatively to the polyether sulfone (PES), a transparent thermoplastic resin or a transparent thermosetting resin can be used. However, engineering plastics of which polyether sulfone (PES) is a representative, is a preferred resin on the points of transparency as well as weather-resistance.

**Claims**

1. A red phosphor represented by the general formula: CaS:Eu or $(Ca_{1-x}Sr_x)S$:Eu (where $0 < x \leq 1$), which is excited by a light at a wavelength in an ultraviolet region to visible region (in the order of 250 nm to 610 nm) and emits light in a visible region, the phosphor being doped to contain Ba at a concentration of 0.001 to 1.00 mol% with respect to CaS or $(Ca_{1-x}Sr_x)S$ (where $0 < x \leq 1$), respectively, wherein
Ba is not substituted at a site of the crystal lattice of the phosphor, and
the Ba atoms penetrate into the crystal lattice of the phosphor *or* are present outside the crystal lattice.

2. The red phosphor according to claim 1, provided with a constitution in which a metal oxide, or, a metal oxide layer containing a metal oxide is present on the phosphor particle surface.

3. The red phosphor according to any of claims 1or 2, provided with a constitution in which a ZnO compound containing Zn and O, or a ZnO compound layer including a ZnO compound containing Zn and O is present on the phosphor particle surface.

4. The red phosphor according to claim 1, wherein a center particle size (D50) according to a volume-based particle size distribution obtained through measurement by a laser diffraction scattering grain size distribution measuring method is 0,1 $\mu$m to 100 $\mu$m.

5. A light-emitting element provided with a light source generating an excitation light and the red phosphor according to any of claims 1 to 4.

6. A light-emitting element provided with a light source generating an excitation light and the red phosphor according to any of claims 1 to 4, and a blue or green phosphor.

7. A solar power generator comprising the red phosphor according to any of claims 1 to 4 receiving, among the sunlight, a light containing at least a light in the ultraviolet region or a light in the near-ultraviolet region, and emitting a light in the visible region, and;
a solar battery receiving and converting into an electric signal the light in the visible region emitted by the red phosphor.

8. The solar power generator according to claim 7, provided with a constitution wherein the red phosphor according to any of claims 1 to 4 is coated on the light-collecting surface or the heat-collecting pipe.

**Patentansprüche**

1. Ein roter Phosphor, dargestellt durch die allgemeine Formel: CaS:Eu oder $(Ca_{1-x}Sr_x)S$:Eu (wobei $0<x\leq1$), der durch Licht mit einer Wellenlänge im ultravioletten Bereich bis sichtbaren Bereich (in einer Größenordnung von 250 nm bis 610 nm) angeregt wird und Licht im sichtbaren Bereich emittiert, wobei der Phosphor so dotiert ist, dass er Ba in einer Konzentration von jeweils 0,001 bis 1,00 Mol% in Bezug auf CaS bzw. $(Ca_{1-x}Sr_x)S$ (wobei $0<x\leq1$) enthält, wobei

Ba nicht an einer Stelle des Kristallgitters des Phosphors substituiert ist, und
die Ba-Atome in das Kristallgitter des Phosphors eindringen oder sich außerhalb des Kristallgitters befinden.

2. Der rote Phosphor nach Anspruch 1, bereitgestellt mit einer Konstitution, in der ein Metalloxid oder eine Metalloxidschicht, die ein Metalloxid enthält, auf der Partikeloberfläche des Phosphors vorhanden ist.

3. Der rote Phosphor nach einem der Ansprüche 1 bis 2, bereitgestellt mit einer Konstitution, in der eine ZnO-Verbindung enthaltend Zn und O, oder eine ZnO-Verbindungsschicht, enthaltend eine ZnO-Verbindung enthaltend Zn und O, auf der Partikeloberfläche des Phosphors vorhanden ist.

4. Der rote Phosphor nach Anspruch 1, wobei eine mittlere Partikelgröße (D50) gemäß einer volumenbasierten Partikelgrößenverteilung, die durch Messung mittels eines Laserbeugungs-Streuungs-Messverfahrens der Korngrößenverteilung erhalten wird, 0,1 $\mu$m bis 100 $\mu$m beträgt.

5. Ein lichtemittierendes Element, das eine Lichtquelle aufweist, die ein Anregungslicht erzeugt, und den roten Phosphor nach einem der Ansprüche 1 bis 4.

6. Ein lichtemittierendes Element, das eine Lichtquelle aufweist, die ein Anregungslicht erzeugt, und den roten Phosphor nach einem der Ansprüche 1 bis 4, und einen blauen oder grünen Phosphor.

7. Ein Solarstromgenerator, umfassend den roten Phosphor nach einem der Ansprüche 1 bis 4, der aus Sonnenlicht Licht enthaltend mindestens Licht im ultravioletten Bereich oder Licht im nahen ultravioletten Bereich empfängt und Licht im sichtbaren Bereich emittiert, und;

   eine Solarbatterie, die das vom roten Phosphor emittierte Licht im sichtbaren Bereich empfängt und in ein elektrisches Signal umwandelt.

8. Der Solarstromgenerator nach Anspruch 7, bereitgestellt mit einer Konstitution, worin der rote Phosphor nach einem der Ansprüche 1 bis 4 auf der lichtsammelnden Oberfläche oder dem wärmesammelnden Rohr aufgebracht ist.

## Revendications

1. Luminophore rouge représenté par la formule générale : CaS : Eu ou $(Ca_{1-x}Sr_x)S$ : Eu (où $0 < x \leq 1$), qui est excité par une lumière à une longueur d'onde située entre une région de l'ultraviolet et une région visible (de l'ordre de 250 nm à 610 nm) et émet de la lumière dans une région visible, le luminophore étant dopé pour contenir Ba à une concentration allant de 0,001 à 1,00% en mole par rapport à Cas ou $(Ca_{1-x}Sr_x)S$ (où $0 < x \leq 1$), respectivement, dans lequel
Ba n'est pas substitué au niveau d'un site du réseau cristallin du luminophore, et
les atomes de Ba pénètrent dans le réseau cristallin du luminophore ou sont présents à l'extérieur du réseau cristallin.

2. Luminophore rouge selon la revendication 1, pourvu d'une constitution dans laquelle un oxyde métallique ou une couche d'oxyde métallique contenant un oxyde métallique est présent(e) sur la surface de particules de luminophore.

3. Luminophore rouge selon l'une des revendications 1 et 2, pourvu d'une constitution dans laquelle un composé de ZnO contenant Zn et O, ou une couche de composé de ZnO comportant un composé de ZnO contenant Zn et O, est présent(e) sur la surface de particules de luminophore.

4. Luminophore rouge selon la revendication 1, dans lequel une taille de particule centrale (D50) selon une distribution de taille de particules sur la base du volume obtenue par une mesure par un procédé de mesure de distribution granulométrique par diffusion-diffraction laser est comprise entre 0,1 $\mu$m et 100 $\mu$m.

5. Élément électroluminescent pourvu d'une source de lumière générant une lumière d'excitation et du luminophore rouge selon l'une des revendications 1 à 4.

6. Élément électroluminescent pourvu d'une source de lumière générant une lumière d'excitation et du luminophore rouge selon l'une des revendications 1 à 4, et d'un luminophore bleu ou vert.

7. Générateur d'énergie solaire comprenant le luminophore rouge selon l'une des revendications 1 à 4, recevant, parmi la lumière du soleil, une lumière contenant au moins une lumière dans la région de l'ultraviolet ou une lumière dans la région du proche ultraviolet, et émettant une lumière dans la région visible, et ;
une batterie solaire recevant et convertissant en un signal électrique la lumière dans la région visible émise par le luminophore rouge.

**8.** Générateur d'énergie solaire selon la revendication 7, pourvu d'une constitution dans laquelle le luminophore rouge selon l'une des revendications 1 à 4 est déposé sur la surface de collecte de lumière ou le tuyau collecteur de chaleur.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2004036962 A
- JP 2002080845 A
- JP 2003041250 A
- JP 2005146190 A
- JP 2010215728 A
- JP 2002527570 W
- JP 2007224148 A

**Non-patent literature cited in the description**

- Phosphor Handbook. Ohm Ltd, 25 December 1987